# FASCICULE DE BREVET EUROPEEN

(11) **EP 2 521 262 B1**
(45) Date de publication et mention de la délivrance du brevet: **10.07.2013**
(21) Numéro de dépôt: 12165091.5
(22) Date de dépôt: 23.04.2012
(51) Int. Cl.: H03F 3/08, G01R 15/18, G01R 15/22

(54) **Dispositif d'isolation galvanique**
Vorrichtung zur galvanischen Isolierung
Galvanic isolation device

(30) Priorité: 02.05.2011 FR 1153738
(43) Date de publication de la demande: 07.11.2012
(73) Titulaire: CHAUVIN ARNOUX, 75018 Paris (FR)
(72) Inventeur: Pion, Francisque, J., 74540 Chapeiry (FR)
(74) Mandataire: Cougard, Jean-Marie

(56) Documents cités:
- EP-A1- 0 875 765
- WO-A1-2008/061444
- US-A- 5 517 154

## Description

### Arrière-plan de l'invention

L'invention concerne un dispositif d'isolation galvanique capable de coupler depuis la composante continue jusqu'aux hautes fréquences deux circuits portés à des potentiels galvaniques différents, et s'applique notamment à des instruments de mesures électriques tels que des voltmètres ou des oscilloscopes.

Une difficulté survient lorsque la source dont provient un signal à mesurer et l'instrument de mesure lui-même ne partagent pas un référentiel de masse commun.

Le fonctionnement de l'instrument de mesure en masse flottante n'est alors pas une solution satisfaisante car, d'une part, la précision de la mesure peut être affectée par la présence de courants de masse et, d'autre part, le potentiel de l'instrument de mesure risque d'être porté à un niveau dangereux.

Il a donc été proposé de transmettre un signal à mesurer à travers une barrière d'isolation galvanique interposée entre la source du signal et l'instrument de mesure qui peuvent alors conserver leurs propres référentiels de masse, le fonctionnement de l'instrument de mesure en masse flottante étant ainsi évité.

Un dispositif d'isolation analogique incorporant une telle barrière d'isolation galvanique, et représenté schématiquement en figure 1, est décrit dans le document EP 0 875 765.

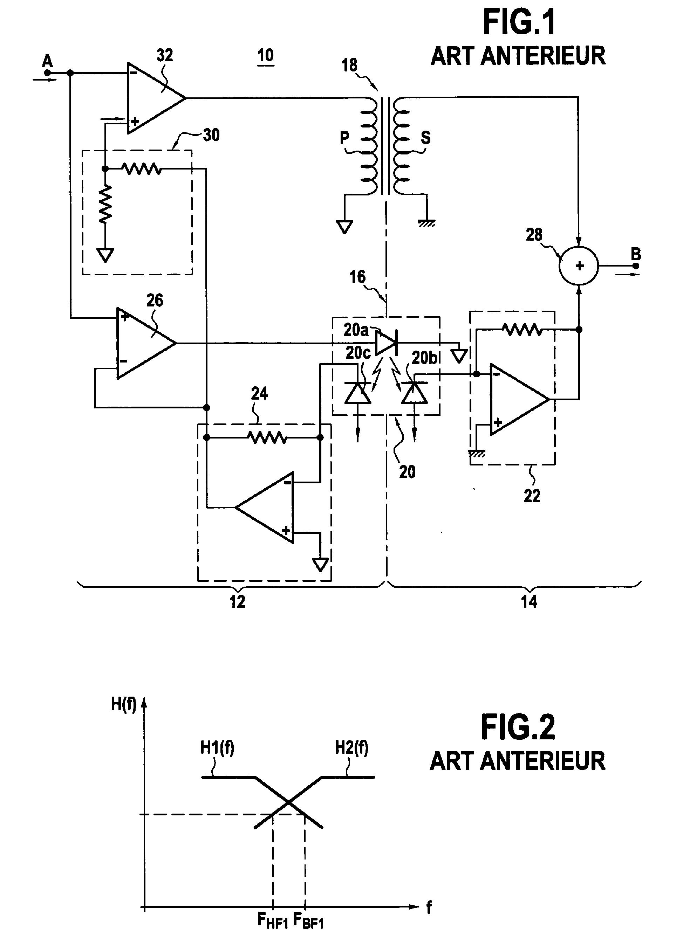

Ce dispositif connu 10 comprend une partie primaire 12 et une partie secondaire 14 isolées l'une de l'autre par une barrière d'isolation 16. Comme montré sur la figure 1, les parties primaire et secondaire sont connectées à des masses respectives indépendantes l'une de l'autre.

Le dispositif 10 reçoit un signal d'entrée sur une entrée A de la partie primaire 12 et est conçu pour délivrer un signal de sortie isolé sur une sortie O de la partie secondaire 14, reproduisant le signal d'entrée 16. Pour ce faire, le dispositif 10 doit présenter une réponse en fréquence plate en, c'est-à-dire fournir un signal de sortie d'amplitude identique (à un coefficient multiplicateur près) à celle du signal d'entrée sur toute la plage de fréquences utiles.

A cet effet, le dispositif comprend deux voies (ou canaux) parallèles, une voie haute fréquence (HF) acheminant la composante HF du signal d'entrée et une voie basse fréquence (BF) acheminant la composante BF du signal d'entrée, le signal de sortie étant obtenu par sommation des composantes BF et HF parvenant dans la partie secondaire.

La voie HF comporte un transformateur 18 dont le primaire P est relié à l'entrée A. Le transformateur 18 reproduit fidèlement sur son enroulement secondaire S la composante HF du signal d'entrée mais sa réponse en fréquence se dégrade rapidement vers les basses fréquences.

La voie BF comporte un opto-coupleur 20 comprenant un émetteur électro-optique 20a, tel qu'une LED, relié à l'entrée A et couplé du côté secondaire à un récepteur opto-électrique, tel qu'une photodiode 20b, le courant issu de celle-ci étant converti en tension par un circuit 22. L'opto-coupleur 20 comprend en outre un deuxième récepteur opto-électrique, tel qu'une photodiode 20c semblable à la photodiode 20b et couplé à l'émetteur 20a, mais situé du côté primaire, le courant issu de la photodiode 20c étant converti en tension par un circuit 24. La tension de sortie du circuit 24 est appliquée à l'entrée inverseuse d'un amplificateur 26 recevant le signal d'entrée sur son entrée non-inverseuse, le circuit 24 et l'amplificateur 26 formant une boucle de réaction permettant de linéariser la réponse de l'opto-coupleur 20. L'opto-coupleur 26 reproduit fidèlement la composante BF du signal d'entrée mais sa réponse en fréquence se dégrade rapidement vers les hautes fréquences.

Le transformateur 18 et l'opto-coupleur 20 forment la barrière d'isolation galvanique 16. Le signal de sortie est obtenu par sommation, au moyen d'un circuit 28 de la composante HF au secondaire du transformateur 18 et de la composante BF en sortie du circuit 22.

La figure 2 montre schématiquement un diagramme de Bode illustrant les réponses en fréquence H1(f) et H2(f) des voies BF et HF, respectivement.

Pour obtenir une réponse en fréquence globale plate, c'est-à-dire pour que le signal de sortie reproduise fidèlement le signal d'entrée dans tout le domaine de fréquences utile, il est nécessaire qu'il y ait correspondance entre la fréquence de coupure haute F_{BF1} de la voie BF (opto-coupleur 20) et la fréquence de coupure basse F_{HF1} de la voie HF (transformateur 18).

A cet effet, une fraction de la tension de sortie du circuit 24, fraction déterminée par un circuit diviseur 30, est appliquée sur l'entrée non-inverseuse d'un amplificateur 32 dont l'entrée inverseuse reçoit le signal d'entrée et dont la sortie est reliée au primaire P du transformateur 18. La tension de sortie du circuit 24 est une image de la composante BF transmise au secondaire via l'opto-coupleur 20. Le rapport de division du circuit 30 est ajusté pour soustraire du signal d'entrée une fraction de la composante BF telle que la fréquence de coupure F_{HF} s'aligne sur la fréquence de coupure F_{BF}.

La Déposante a toutefois constaté que cette technique de compensation du désalignement des fréquences de coupure des voies BF et HF ne garantit pas un résultat totalement satisfaisant, c'est-à-dire l'absence de distorsions significatives du signal de sortie par rapport au signal d'entrée. En effet, il est difficile d'ajuster le rapport de division du circuit 30 de façon optimale. De plus, il n'y a pas de compensation des défauts de réponse asymptotique dans la voie BF résultant de la présence d'ordre supérieur à 1 dans la fréquence de coupure de cette voie. De plus encore, la compensation se faisant par alignement de la fréquence de coupure de la voie HF sur celle de la voie BF, cette dernière fonctionne à pleine bande passante, et il est nécessaire que les restitutions de l'opto-coupleur vers la partie secondaire via la photodiode 20b et vers la partie primaire via la photodiode 20c aient mêmes bandes passantes et mêmes gains ce qui impose des réglages délicats et le choix de composants présentant de faibles écarts entre leurs caractéristiques.

### Objet et résumé de l'invention

L'invention a pour but de remédier aux inconvénients précités en proposant un dispositif d'isolation analogique capable d'assurer une reproduction fidèle, sans distorsion notable, d'un signal d'entrée, dans un très large domaine de fréquences.

Pour obtenir une fonction de transfert totalement exempte de distorsion d'amplitude ou de phase, trois conditions doivent être réunies :
- égalité des gains HF et BF dans chacune des bandes passantes ;
- égalité des fréquences de coupure à -3 dB ;
- avoir les mêmes ordres de coupures (si le passe haut (HF) est du premier ordre, le passe-bas (BF) doit l'être aussi).

Ce but est atteint grâce à un dispositif d'isolation analogique comprenant une partie primaire ayant une entrée apte à recevoir un signal d'entrée et une partie secondaire séparée de la partie primaire par une barrière d'isolation galvanique et ayant une sortie pour délivrer un signal de sortie reproduisant le signal d'entrée,

la partie primaire et la partie secondaire comportant une voie haute fréquence ayant une fréquence de coupure basse et configurée pour recevoir le signal d'entrée dans la partie primaire et pour restituer dans la partie secondaire, à partir du signal d'entrée, une composante haute fréquence, et une voie basse fréquence ayant une fréquence de coupure haute et configurée pour recevoir le signal d'entrée dans la partie primaire et pour restituer dans la partie secondaire, à partir du signal d'entrée, une composante basse fréquence, afin de former le signal de sortie à partir des composantes haute fréquence et basse fréquence,

le dispositif étant muni d'un circuit d'asservissement configuré pour recevoir, dans la partie primaire, un signal de consigne représentatif du signal d'entrée et un signal dit image représentatif du signal de sortie et pour appliquer, sur au moins l'une des voies haute fréquence et basse fréquence, un signal de correction fonction de la différence entre le signal image et le signal de consigne afin de faire tendre cette différence vers zéro.

Ce dispositif est avantageux en ce qu'il réalise un asservissement en boucle fermée capable de compenser les distorsions du signal de sortie par rapport au signal d'entrée de façon dynamique et quelles qu'en soient les causes.

Le signal de correction peut être appliqué sur la voie basse fréquence uniquement, sur la voie haute fréquence uniquement ou sur les deux.

Selon une particularité du dispositif, la partie primaire comprend un sommateur apte à produire le signal image par sommation d'un premier signal représentatif de ladite composante basse fréquence et d'un deuxième signal représentatif de ladite composante haute fréquence.

Le premier signal et le deuxième signal peuvent être sous la forme de courants ou de tensions.

Selon une autre particularité du dispositif, la voie basse fréquence comprend un coupleur électro-optique formant une partie de la barrière d'isolation galvanique et ayant un émetteur électro-optique, un premier récepteur opto-électrique situé dans la partie secondaire et couplé à l'émetteur pour produire un courant permettant d'élaborer ladite composante basse fréquence et un deuxième récepteur opto-électrique situé dans la partie primaire et couplé à l'émetteur pour produire un courant permettant d'élaborer ledit premier signal représentatif de ladite composante basse fréquence. Le signal de correction V_{COR} peut être appliqué à un circuit de linéarisation de l'opto-coupleur relié à l'émetteur électro-optique.

Selon encore une autre particularité du dispositif, la voie haute fréquence comprend un transformateur formant une partie de la barrière d'isolation galvanique et ayant un primaire situé dans la partie primaire et un secondaire situé dans la partie secondaire pour obtenir ladite composante haute fréquence à partir d'une tension prélevée au secondaire du transformateur et pour obtenir ledit deuxième signal représentatif de ladite composante haute fréquence à partir d'une tension prélevée au primaire du transformateur. Le signal de correction V_{COR} peut être sous forme d'une tension appliquée au primaire du transformateur.

De préférence, le circuit d'asservissement a une fréquence de coupure haute au moins 100 fois supérieure à la fréquence de coupure basse de la voie haute fréquence. Ainsi, au-delà de la fréquence de coupure du circuit d'asservissement, la transmission du signal d'entrée se fait pratiquement uniquement via la voie haute fréquence et le problème d'un désalignement entre les fréquences de coupure des voies basse fréquence et haute fréquence ne se pose plus.

### Brève description des dessins

L'invention sera mieux comprise à la lecture de la description faite ci-après, à titre indicatif mais non limitatif, en référence aux dessins annexés sur lesquels :
- la figure 1, déjà décrite, représente un dispositif d'isolation connu de l'art antérieur ;
- la figure 2, déjà décrite, représente les réponses en fréquence d'un transformateur et d'un opto-coupleur du dispositif de la figure 1 ;
- la figure 3 représente un dispositif d'isolation selon un premier mode de réalisation de l'invention ;
- la figure 4A représente une réponse en fréquence d'un dispositif tel que celui de la figure 3 et la variation du signal de correction en l'absence d'application du signal de correction ;
- la figure 4B représente la réponse en fréquence du dispositif de la figure 3 et la variation du signal de la correction, avec application du signal correction ; et
- les figures 5, 6 et 7 représentent des dispositifs d'isolation selon respectivement un deuxième, un troisième et un quatrième mode de réalisation de l'invention.

### Description détaillée de modes de réalisation

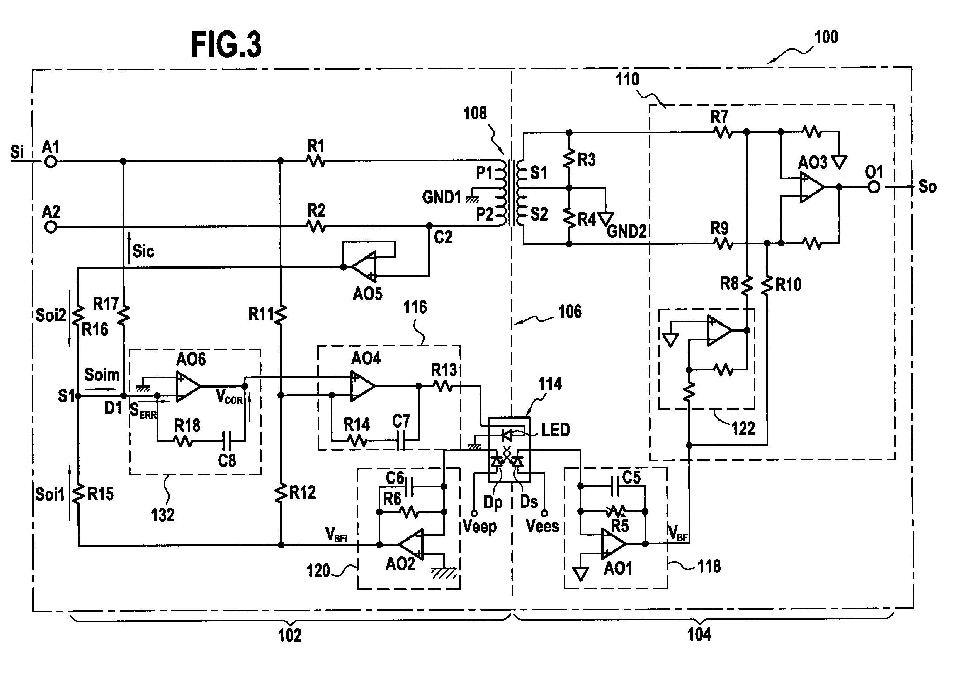

Le dispositif d'isolation de la figure 3 comprend une partie primaire 102 et une partie secondaire 104 isolées l'une de l'autre par une barrière d'isolation galvanique 106. Ces deux parties présentent des masses respectives indépendantes l'une de l'autre, notées GND1 et GND2. Le dispositif 100 est conçu pour recevoir un signal d'entrée Si en entrée de la partie primaire et délivrer, en sortie de la partie secondaire, un signal de sortie So reproduisant le signal Si, le cas échéant à un coefficient multiplicateur près différent de 1. Dans le mode de réalisation de la figure 3, le signal d'entrée Si est un signal différentiel reçu sur une entrée bipolaire A1, A2 tandis que le signal de sortie est un signal non différentiel émis sur une sortie unipolaire O1

Le dispositif d'isolation 100 comprend deux voies (ou canaux) parallèles, à savoir une voie haute fréquence (HF) et une voie basse fréquence (BF).

La voie HF comporte un transformateur 108 formant une partie de la barrière d'isolation 106. Dans la partie primaire 102, le transformateur a un primaire avec deux demi-enroulements P1, P2 ayant des premières extrémités reliées aux ports d'entrée A1, A2 via des résistances respectives R1, R2 et des deuxièmes extrémités reliées en commun à la masse GND1. Dans la partie secondaire 104, le transformateur 108 a un secondaire avec deux demi-enroulements S1, S2 ayant des premières extrémités reliées à un circuit sommateur 110 et des deuxièmes extrémités reliées à la masse GND2. Des résistances R3, R4 branchées entre, respectivement, les premières extrémités des demi-enroulements S1, S2 et la masse GND2 permettent d'ajuster les fractions des tensions prélevées sur les demi-enroulements S1, S2 et appliquées au circuit sommateur 110 et de charger le secondaire du transformateur 108. On notera que les connexions des demi-enroulements à la masse du côté primaire et du côté secondaire permettent un bonne réjection des modes communs sans nécessiter l'usage d'un écran dans le transformateur.

Le transformateur 108 présente une fréquence de coupure basse F_{HF} (fréquence de coupure de la voie HF). Ainsi, à partir du signal d'entrée, la voie HF permet de restituer dans la partie secondaire 104, une composante haute fréquence qui, dans le mode de réalisation de la figure 3 est appliquée au circuit sommateur 110 sous forme différentielle.

La voie BF comporte un opto-coupleur 114 formant une partie de la barrière d'isolation 106. L'opto-coupleur 114 comprend un émetteur électro-optique, typiquement une diode électroluminescente LED, couplé optiquement à un premier récepteur opto-électrique Dp situé dans la partie secondaire et à un deuxième récepteur opto-électrique situé dans la partie primaire. Les récepteurs Ds et Dp sont typiquement des photodiodes auxquelles des tensions de polarisation respectives Vees et Veep sont appliquées. L'émetteur LED est relié à l'un des ports d'entrée (A1 dans l'exemple illustré) via notamment un circuit de linéarisation 116 décrit plus loin. Le courant issu du récepteur Ds est converti en tension au moyen d'un circuit convertisseur 118 comprenant un amplificateur opérationnel AO1 ayant une entrée inverseuse reliée au récepteur Ds et une entrée non-inverseuse reliée à la masse GND2. Un circuit formé par une résistance R5 en parallèle sur un condensateur C5 est branché entre la sortie de l'amplificateur AO1 et l'entrée inverseuse de celui-ci. De façon similaire, le courant issu du récepteur Dp est converti en tension au moyen d'un circuit convertisseur 120 comprenant un amplificateur opérationnel A02 ayant une entrée inverseuse reliée au récepteur Dp et une entrée non-inverseuse reliée à la masse GND1. Un circuit formé par une résistance R6 en parallèle sur un condensateur C6 est branché entre la sortie de l'amplificateur AO2 et l'entrée inverseuse de celui-ci.

L'ensemble formé par l'émetteur LED et le récepteur Ds présente une fréquence de coupure haute F_{BF} (fréquence de coupure de la voie BF). Ainsi, à partir du signal d'entrée, la voie BF permet de restituer, dans la partie secondaire 104, une composante basse fréquence V_{BF} disponible en sortie du convertisseur 118 et appliquée au circuit sommateur 110.

Le circuit sommateur 110 comporte un amplificateur opérationnel AO3 ayant une entrée non-inverseuse reliée à la première extrémité du demi-enroulement S1 via une résistance R7 et reliée à la sortie du circuit convertisseur 118 via un circuit inverseur 122 et une résistance R8. L'entrée inverseuse de l'amplificateur AO3 est reliée à la première extrémité du demi-enroulement S2 via une résistance R9 et est reliée à la sortie du circuit convertisseur 118 via une résistance R10. La sortie de l'amplificateur A03 est reliée à la sortie 01 de la partie secondaire. L'inverseur 122 permet de reconstruire une composante basse fréquence sous forme différentielle pour la sommer avec la composante haute fréquence différentielle et l'amplificateur A03 délivre le signal de sortie sous forme non-différentielle (unipolaire).

Il serait possible de disposer d'un signal de sortie sous forme différentielle en utilisant un deuxième opto-coupleur analogue à l'opto-coupleur 114 et relié au deuxième port d'entrée afin de disposer d'une composante basse fréquence réellement sous forme différentielle et de la combiner avec la composante haute fréquence sous forme différentielle, le dispositif d'isolation étant alors intégralement bipolaire.

En sortie du convertisseur 120, on dispose d'une tension V_{BFi} qui est égale ou sensiblement égale à la composante basse fréquence V_{BF} dans la mesure où les gains des ensembles formés respectivement par l'émetteur LED et le récepteur Ds et par l'émetteur LED et le récepteur Dp sont sensiblement égaux, de même que leurs fréquences de coupure haute, les amplificateurs AO1 et AO2 étant identiques. La résistance R5 est avantageusement ajustable afin de pouvoir égaliser ces gains, tandis que les condensateurs C5 et C6 permettent d'égaliser les fréquences de coupure haute.

Le circuit de linéarisation 116 comprend un amplificateur opérationnel AO4 dont l'entrée inverseuse est reliée au port d'entrée A1 via une résistance R11 et à la sortie du convertisseur 120 via une résistance R12. La sortie de l'amplificateur A04 est reliée à l'émetteur LED via une résistance R13 et un circuit formé par un condensateur C7 en série avec une résistance R14 est branché entre la sortie de l'amplificateur AO4 et l'entrée inverseuse de celui-ci. Le rapport entre les résistances R11 et R12 détermine le gain de la voie BF.

Afin de disposer d'un signal de sortie So reproduisant fidèlement le signal d'entrée Si, il est nécessaire de corriger un désalignement entre les fréquences de coupure F_{BF} et F_{HF} des voies BF et HF. Cela est réalisé conformément à l'invention en reproduisant dans la partie primaire un signal image Soim représentatif du signal So et en injectant dans la voie BF et/ou dans la voie HF un signal de correction élaboré à partir de l'écart entre les signaux Si et Soim.

Dans le mode de réalisation de la figure 3, le signal de correction V_{COR} est injecté dans la voie BF.

Pour élaborer le signal image Soim, on réalise une sommation entre un premier signal Soi1 représentatif de la composante BF transmise dans la partie secondaire 104 par l'opto-coupleur 114 et un deuxième signal Soi2 représentatif de la composante HF transmise dans la partie secondaire 104 par le transformateur 108. La sortie du convertisseur 120 est reliée à un noeud de sommation S1 via une résistance R15 pour fournir le signal Soi1 sous forme d'un courant. La tension à la première extrémité d'un des demi-enroulements au primaire du transformateur, ici l'enroulement P2, est l'image de la tension au demi-enroulement secondaire correspondant. La première extrémité C2 du demi-enroulement P2 (qui est reliée au port d'entrée A2 via la résistance R2) est reliée au noeud de sommation S1 via un amplificateur opérationnel AO5 et une résistance R16 pour fournir le signal Soi2 sous forme d'un courant. Dans l'exemple où le transformateur 108 et l'opto-coupleur 114 ont même gain et l'amplificateur AO5 a un gain égal à 1, on choisit les valeurs des résistances R15 et R16 de sorte que R15=2xR16 pour tenir compte du fait que la tension au point C2 ne représente que la moitié de la composante HF globale transmise dans la partie secondaire 104.

Le signal image (courant) Soim, obtenu par sommation au point S1 des courants Soi1 et Soi2, est appliqué à un point de sommation D1 qui est par ailleurs relié au port d'entrée A1 via une résistance R17. Ainsi, le point de sommation D1 reçoit le signal image Soim et un signal de consigne Sic représentatif du signal d'entrée Si, avec des polarités opposées. La résistance R17 est choisie pour que les signaux sous forme de courants Soim et Sic représentent les signaux So et Si dans un même rapport pour être utilement comparés (dans l'exemple où le signal de sortie So reproduit le signal d'entrée Si dans un rapport égal à 1).

Le signal d'erreur sous forme de courant S_{ERR} représentant l'écart entre Sic et Soim et issu du point de sommation D1 est appliqué à l'entrée d'un circuit correcteur 132 de type PI (proportionnel/intégral). De façon classique, le circuit 132 comprend un amplificateur opérationnel AO6 ayant son entrée non-inverseuse à la masse GND1, son entrée inverseuse reliée au point de sommation D1 et sa sortie reliée à son entrée inverseuse par un circuit formé d'un condensateur C8 en série avec une résistance R18. On dispose ainsi en sortie du circuit correcteur PI 132 d'un signal de correction, en l'espèce une tension V_{COR}, qui est appliquée à la voie BF en étant injectée dans le circuit de linéarisation 116, au niveau de l'entrée non-inverseuse de l'amplificateur A04. Ainsi, le courant injecté dans l'émetteur LED de l'opto-coupleur est modifié d'une quantité fonction de l'écart entre l'image Soim du signal de sortie et le signal d'entrée Si.

On réalise ainsi un asservissement en boucle fermée, le signal de correction V_{COR} modifiant le fonctionnement de la voie BF pour annuler la différence entre l'image Soim du signal de sortie et le signal d'entrée Si, c'est-à-dire en alignant la fréquence de coupure F_{BF} de la voie BF sur celle F_{HF} de la voie HF ainsi que les réponses asymptotiques (ordre de coupure).

Le circuit d'asservissement, qui est formé par les éléments permettant d'élaborer le signal image Soim et le signal d'erreur S_{ERR} et le circuit correcteur PI 132 délivrant le signal de correction V_{COR}, possède en lui-même une fréquence de coupure haute F_{CASS} et est de préférence conçu pour que cette fréquence de coupure haute soit très supérieure à la fréquence de coupure basse F_{HF} de la voie HF. Avantageusement, F_{CASS} ≥ 100 F_{HF}, voire F_{CASS} ≥ 1000 F_{HF}. Ainsi, au-delà de la fréquence F_{CASS}, l'intégralité ou la quasi intégralité du signal d'entrée est transmise par la voie HF uniquement de sorte que la perte d'efficacité de l'asservissement devient sans conséquence. On peut fixer la fréquence de coupure haute F_{CASS} en agissant sur la capacité C8 ou sur les valeurs des résistances R16, R17 et/ou R15.

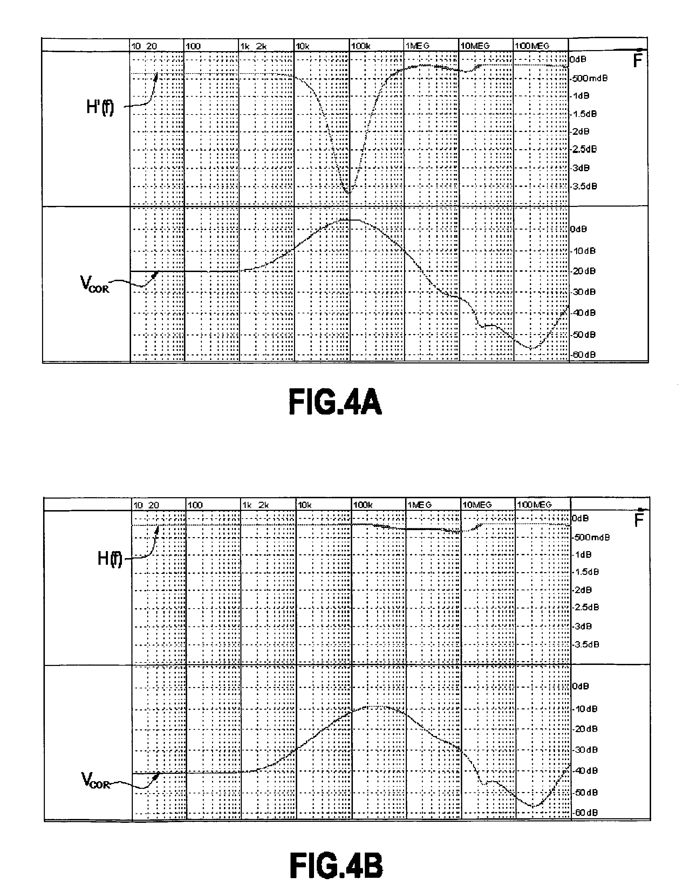

La figure 4A illustre la réponse en fréquence H'(f) d'un dispositif d'isolation tel que celui de la figure 3 et la variation du signal de correction V_{COR}, en l'absence d'application du signal de correction, c'est-à-dire en ouvrant la liaison entre le circuit correcteur PI 132 et le circuit de linéarisation 116, l'amplificateur A04 de celui-ci ayant son entrée non-inverseuse à la masse GND1. On constate une forte distorsion du signal de sortie dans un domaine de fréquence intermédiaire en raison d'un désalignement entre les fréquences de coupure F_{BF} et F_{HF}, et la variation correspondante du signal de correction V_{COR} (plus faible en boucle fermée).

La figure 4B illustre la réponse en fréquence H(f) du dispositif de la figure 3, avec application du signal de correction V_{COR}, et la variation correspondante du signal de correction. On constate la quasi-absence de distorsions dans le signal de sortie, l'asservissement en boucle fermée permettant de compenser différentes causes de distorsion comme, notamment, un défaut de réponse asymptotique dans la voie BF. En outre, en alignant la fréquence de coupure de la voie BF sur celle, sensiblement plus basse, de la voie HF, on fait fonctionner la voie BF dans une bande passante réduite, ce qui permet de réduire l'influence de signaux parasites transmis par couplage capacitif, donc d'améliorer la réjection de modes communs dans la voie BF.

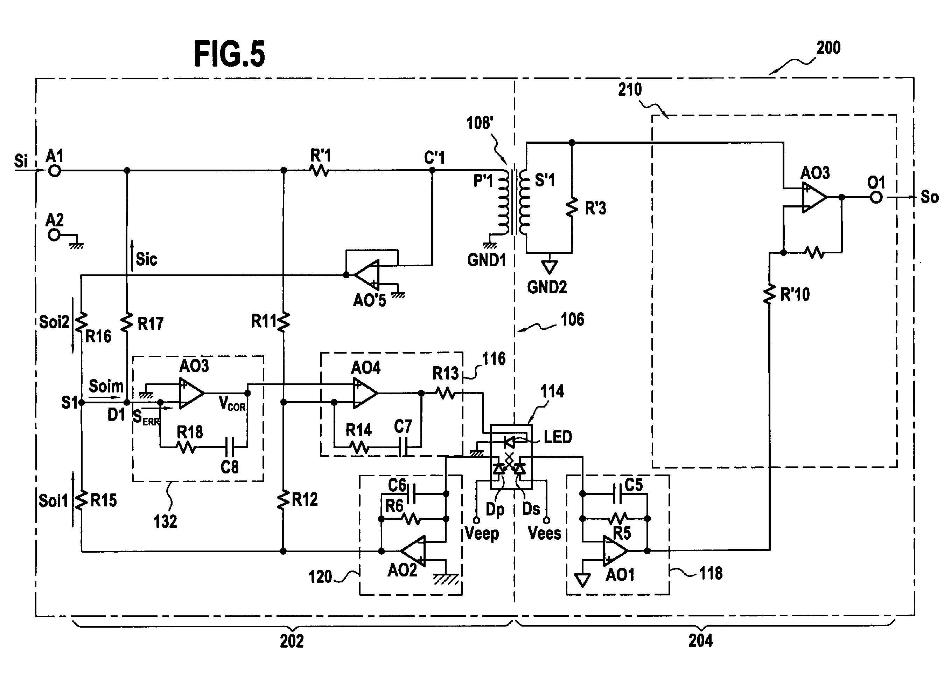

D'autres modes de réalisation sont illustrés par les figures 5, 6 et 7.

Dans le dispositif d'isolation 200 de la figure 5, l'entrée du dispositif d'isolation est unipolaire, le signal d'entrée Si non différentiel étant reçu sur la borne A1 tandis que la borne A2 est portée à la masse GND1. Les éléments communs entre le mode de réalisation de la figure 5 et celui de la figure 3 portent les mêmes références et ne seront pas à nouveau décrits.

Dans la partie primaire 202, le transformateur 108' comporte un seul enroulement primaire P'1 ayant une première extrémité reliée au port d'entrée A1 via une résistance R'1 et une deuxième extrémité reliée à la masse GND1. Dans la partie secondaire 204, le transformateur 108' comporte un seul enroulement secondaire S'1 ayant une première extrémité reliée à un circuit sommateur 210 et une deuxième extrémité reliée à la masse GND2. La première extrémité de l'enroulement S'1 est en outre reliée à la masse GND2 via une résistance R'3. Le circuit sommateur 210 comprend essentiellement un amplificateur opérationnel ayant une entrée non-inverseuse reliée à la première extrémité de l'enroulement S'1 et une entrée inverseuse reliée à la sortie du circuit convertisseur 118 via une résistance R'10, les résistances R'3 et R'10 permettant d'ajuster le rapport entre les composantes HF et BF appliquées au circuit sommateur 210.

Dans la partie primaire 202, le signal Soim image du signal de sortie So est fourni au point de sommation S1 qui est relié à la sortie du circuit convertisseur 120 via la résistance R15 et qui est relié à la première extrémité C'1 de l'enroulement P' via un amplificateur opérationnel AO'5 et une résistance R16, le rapport entre les valeurs des résistances R15 et R16 étant ici égal à 1. Plus précisément, l'amplificateur AO'5 a son entrée inverseuse reliée au point C'1 et à sa sortie et a son entrée non-inverseuse reliée à la masse GND1. Le signal Soin est appliqué au point de sommation D1 qui reçoit également le signal Sic en étant relié au port d'entrée A1 via la résistance R17. Les signaux Soim et Sic (sous forme de courants) ont des polarités opposées. Le signal d'erreur S_{ERR} issu du point D1 est transformé par le circuit correcteur PI 132 en signal de correction V_{COR} appliqué au circuit de linéarisation 116, comme dans le mode de réalisation de la figure 3.

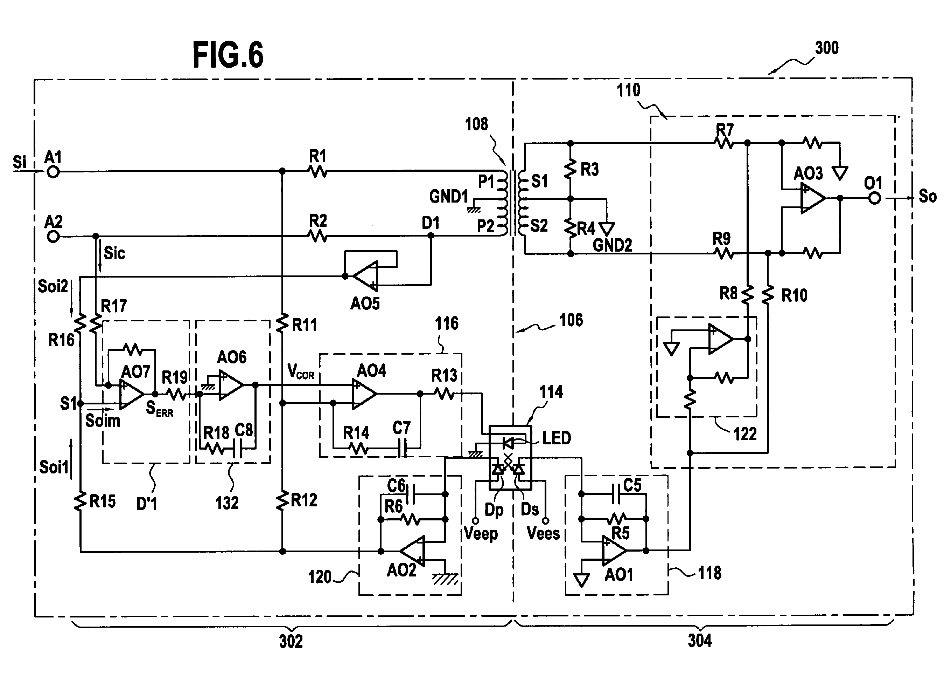

Dans le dispositif d'isolation 300 de la figure 6, le signal image Soim est sous forme d'une tension. Les éléments communs entre les dispositifs d'isolation 300 et 100 portent les mêmes références et ne sont pas à nouveau décrits.

La partie secondaire 304 du dispositif d'isolation 300 est similaire à la partie secondaire 104 du dispositif d'isolation 100.

La partie primaire 302 du dispositif 300 se distingue de la partie primaire 102 du dispositif 100 en ce que le point de sommation D1 est remplacé par un circuit différentiel D'1 avec un amplificateur opérationnel A07 dont l'entrée inverseuse est reliée au point de sommation S1 pour recevoir le signal Soim et dont l'entrée non-inverseuse est reliée au port B1 pour recevoir le signal Sic. Le signal d'erreur S_{ERR} sous forme de tension en sortie de l'amplificateur AO7 est appliqué au circuit correcteur PI 132 via une résistance R19 pour élaborer le signal de correction V_{COR} appliqué au circuit de linéarisation 116.

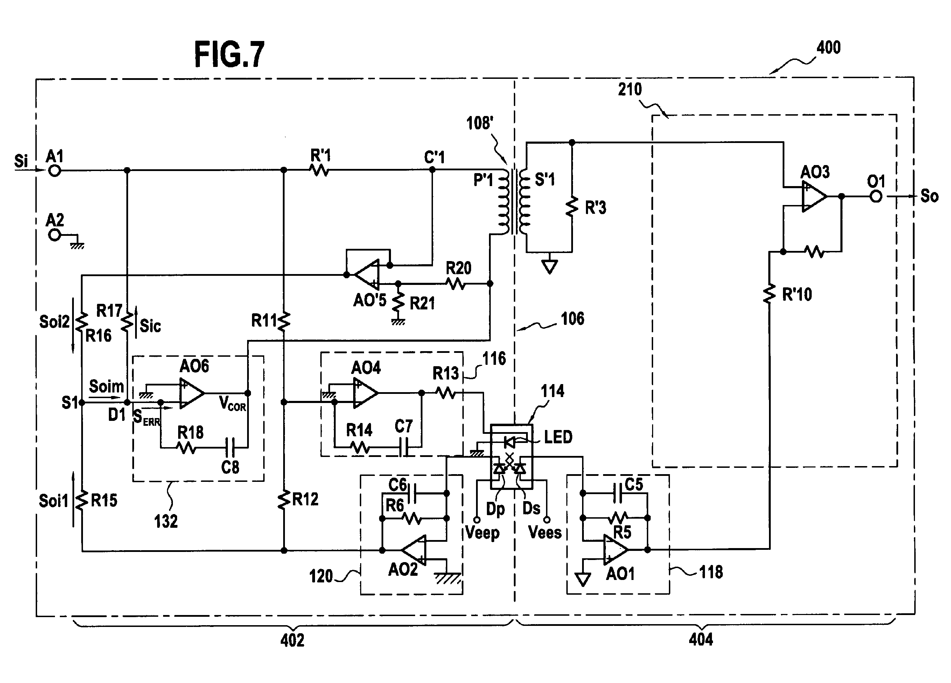

Dans le dispositif d'isolation 400 de la figure 7, le signal d'entrée Si est sous forme unipolaire et le signal de correction V_{COR} est appliqué sur la voie HF. Les éléments communs entre le dispositif d'isolation 400 et celui 200 de la figure 5 portent les mêmes références et ne seront pas à nouveau décrits.

La partie secondaire 404 du dispositif d'isolation 400 est similaire à la partie secondaire 204 du dispositif d'isolation 200.

Dans la partie primaire 402 du dispositif d'isolation 400, la deuxième extrémité de l'enroulement primaire P'1 du transformateur 108' est reliée à la sortie du circuit correcteur PI 132 délivrant le signal de correction V_{COR}. Dans le circuit de linéarisation 116, l'entrée non inverseuse de l'amplificateur A04 est reliée à la masse GND1.

En outre, l'entrée non inverseuse de l'amplificateur AO'5 est reliée non pas directement à la masse GND1, mais au point milieu d'un diviseur de tension formé par des résistances R20 et R21 en série entre la deuxième extrémité de l'enroulement P'1 et la masse GND1. Les valeurs des résistances R20 et R21 sont choisies pour obtenir en sortie de l'amplificateur AO'5 un signal Soi2 représentant la composante HF restituée au secondaire du transformateur sans influence du signal de correction V_{COR} injecté du côté primaire (amplificateur différentiel).

On notera que des particularités des modes de réalisation décrits plus haut pourront être combinées de diverses façons, par exemple en réalisant un dispositif d'isolation à entrée bipolaire et application du signal de correction dans la voie HF ou en élaborant un signal d'erreur sous forme d'une tension comme dans le mode de réalisation de la figure 6 mais avec signal d'entrée bipolaire et/ou application du signal de correction dans la voie HF. En outre, comme déjà indiqué, la voie BF pourra être réalisée sous forme bipolaire.

De plus, dans les diverses variantes envisageables, il est possible de remplacer le transformateur de la voie HF et/ou l'opto-coupleur de la voie BF par d'autres composants remplissant respectivement la même fonction. Ainsi, le transformateur peut être remplacé par tout autre dispositif apte à restituer, à partir du signal d'entrée, une composante haute fréquence dans la partie secondaire. Le transformateur 108 ou 108' peut, par exemple, être remplacé par un couplage par condensateurs en différentiel. De même, l'opto-coupleur 114 peut être remplacé par tout autre dispositif apte à restituer, à partir du signal d'entrée, une composante basse fréquence dans la partie secondaire. On peut, par exemple, remplacer l'opto-coupleur 114 par un système de transmission fonctionnant par modulation/démodulation de la largeur d'impulsion ou de la fréquence d'un signal (système PWM, Sigma Delta, FM...). La transmission au travers de la barrière d'isolation peut alors se faire via un coupleur analogique (canal radio...) ou via un coupleur numérique.

Selon l'une des alternatives de l'invention, il est également possible d'ajouter un enroulement supplémentaire au primaire du transformateur de la voie HF, cet enroulement supplémentaire fournissant alors le signal Soi2 côté primaire.

## Revendications

1. Dispositif d'isolation analogique (100 ; 200 ; 300 ; 400) comprenant une partie primaire (102 ; 202 ; 302 ; 402) ayant une entrée (A1, A2) apte à recevoir un signal d'entrée (Si) et une partie secondaire (104 ; 204 ; 304 ; 404) séparée de la partie primaire par une barrière d'isolation galvanique et ayant une sortie (O1) pour délivrer un signal de sortie (So) reproduisant le signal d'entrée,
la partie primaire et la partie secondaire comportant une voie haute fréquence ayant une fréquence de coupure basse et configurée pour recevoir le signal d'entrée dans la partie primaire et pour restituer dans la partie secondaire, à partir du signal d'entrée, une composante haute fréquence, et une voie basse fréquence ayant une fréquence de coupure haute et configurée pour recevoir le signal d'entrée dans la partie primaire et pour restituer dans la partie secondaire, à partir du signal d'entrée, une composante basse fréquence, afin de former le signal de sortie à partir des composantes haute fréquence et basse fréquence,
le dispositif étant **caractérisé par** un circuit d'asservissement (D1, 132 ; D'1, 132) configuré pour recevoir, dans la partie primaire, un signal de consigne (Sic) représentatif du signal d'entrée (Si) et un signal dit image (Soim) représentatif du signal de sortie (So) et pour appliquer, sur au moins l'une des voies haute fréquence et basse fréquence, un signal de correction (V_{COR}) fonction de la différence entre le signal image et le signal de consigne afin de faire tendre cette différence vers zéro.

2. Dispositif selon la revendication 1, **caractérisé en ce que** le signal de correction (V_{COR}) est appliqué uniquement sur la voie basse fréquence.

3. Dispositif selon la revendication 1, **caractérisé en ce que** le signal de correction (V_{COR}) est appliqué uniquement sur la voie haute fréquence.

4. Dispositif selon l'une quelconque des revendications 1 à 3, **caractérisé en ce que** la partie primaire (102) comprend un sommateur apte à produire le signal image (Soim) par sommation d'un premier signal représentatif de ladite composante basse fréquence et d'un deuxième signal représentatif de ladite composante haute fréquence.

5. Dispositif selon la revendication 4, **caractérisé en ce que** le premier signal et le deuxième signal sont sous la forme de courants.

6. Dispositif selon la revendication 4, **caractérisé en ce que** le premier signal et le deuxième signal sont sous la forme de tensions.

7. Dispositif selon l'une quelconque des revendications 4 à 6, **caractérisé en ce que** la voie basse fréquence comprend un coupleur électro-optique (114) formant une partie de la barrière d'isolation galvanique et ayant un émetteur électro-optique (LED), un premier récepteur opto-électrique (Ds) situé dans la partie secondaire et couplé à l'émetteur pour produire un courant permettant d'élaborer ladite composante basse fréquence et un deuxième récepteur opto-électrique (Dp) situé dans la partie primaire et couplé à l'émetteur pour produire un courant permettant d'élaborer ledit premier signal représentatif de ladite composante basse fréquence.

8. Dispositif selon la revendication 7, **caractérisé en ce que** la voie basse fréquence comprend, dans la partie primaire, un circuit (116) de linéarisation de l'opto-coupleur (114) relié à l'émetteur électro-optique.

9. Dispositif selon la revendication 8, **caractérisé en ce que** le signal de correction (V_{COR}) est appliqué au circuit de linéarisation (116).

10. Dispositif selon l'une quelconque des revendications 4 à 6, **caractérisé en ce que** la voie haute fréquence comprend un transformateur (108 ; 108') formant une partie de la barrière d'isolation galvanique (116) et ayant un primaire (P1, P2 ; P'1) situé dans la partie primaire et un secondaire (S1, S2 ; S'1) situé dans la partie secondaire pour obtenir ladite composante haute fréquence à partir d'une tension prélevée au secondaire du transformateur et pour obtenir ledit deuxième signal représentatif de ladite composante haute fréquence à partir d'une tension prélevée au primaire du transformateur.

11. Dispositif selon la revendication 10, **caractérisé en ce que** le signal de correction (V_{COR}) est sous forme d'une tension appliquée au primaire du transformateur.

12. Dispositif selon l'une quelconque des revendications 1 à 11, **caractérisé en ce que** le circuit d'asservissement a une fréquence de coupure haute au moins 100 fois supérieure à la fréquence de coupure basse de la voie haute fréquence.

13. Instrument de mesure électrique muni d'un dispositif d'isolation analogique selon l'une quelconque des revendications 1 à 12.

## Patentansprüche

1. Vorrichtung zur analogen Isolierung (100; 200; 300; 400), umfassend einen Primärteil (102; 202; 302; 402), der einen Eingang (A1, A2) aufweist, welcher geeignet ist, ein Eingangssignal (Si) zu empfangen, sowie einen Sekundärteil (104; 204; 304; 404), der von dem Primärteil durch eine galvanische Isolationsbarriere getrennt ist und einen Ausgang (O1) aufweist, um ein das Eingangssignal wiedergebendes Ausgangssignal (So) zu liefern,
wobei der Primärteil und der Sekundärteil einen Hochfrequenzkanal, der eine untere Grenzfrequenz hat und dazu ausgebildet ist, das Eingangssignal in dem Primärteil zu empfangen und in dem Sekundärteil aus dem Eingangssignal eine Hochfrequenzkomponente zu rekonstruieren, sowie einen Niederfrequenzkanal umfassen, der eine obere Grenzfrequenz hat und dazu ausgebildet ist, das Eingangssignal in dem Primärteil zu empfangen und in dem Sekundärteil aus dem Eingangssignal eine Niederfrequenzkomponente zu rekonstruieren, um das Ausgangssignal mit Hilfe der Hochfrequenz- und Niederfrequenzkomponenten zu bilden,
wobei die Vorrichtung durch einen Regelkreis (D1, 132; D'1, 132) gekennzeichnet ist, der dazu ausgebildet ist, in dem Primärteil ein Sollsignal (Sic), das für das Eingangssignal (Si) repräsentativ ist, und ein sogenanntes Bildsignal (Soim), das für das Ausgangssignal (So) repräsentativ ist, zu empfangen und an wenigstens einen der Hochfrequenz- und Niederfrequenzkanäle ein von der Differenz zwischen dem Bildsignal und dem Sollsignal abhängiges Korrektursignal (V_{COR}) anzulegen, um diese Differenz gegen Null streben zu lassen.

2. Vorrichtung nach Anspruch 1, **dadurch gekennzeichnet, daß** das Korrektursignal (V_{COR}) lediglich an den Niederfrequenzkanal angelegt wird.

3. Vorrichtung nach Anspruch 1, **dadurch gekennzeichnet, daß** das Korrektursignal (V_{COR}) lediglich an den Hochfrequenzkanal angelegt wird.

4. Vorrichtung nach einem der Ansprüche 1 bis 3, **dadurch gekennzeichnet, daß** der Primärteil (102) einen Summierer umfaßt, der geeignet ist, das Bildsignal (Soim) durch Summieren eines ersten Signals, das für die Niederfrequenzkomponente repräsentativ ist, und eines zweiten Signals, das für die Hochfrequenzkomponente repräsentativ ist, zu erzeugen.

5. Vorrichtung nach Anspruch 4, **dadurch gekennzeichnet, daß** das erste Signal und das zweite Signal in Form von Strömen vorliegen.

6. Vorrichtung nach Anspruch 4, **dadurch gekennzeichnet, daß** das erste Signal und das zweite Signal in Form von Spannungen vorliegen.

7. Vorrichtung nach einem der Ansprüche 4 bis 6, **dadurch gekennzeichnet, daß** der Niederfrequenzkanal einen elektrooptischen Koppler (114) umfaßt, welcher einen Teil der galvanischen Isolationsbarriere bildet und einen elektrooptischen Sender (LED), einen ersten optoelektrischen Empfänger (Ds), der sich in dem Sekundärteil befindet und mit dem Sender gekoppelt ist, um einen Strom zu erzeugen, der das Erstellen der Niederfrequenzkomponente ermöglicht, sowie einen zweiten optoelektrischen Empfänger (Dp) umfaßt, der sich in dem Primärteil befindet und mit dem Sender gekoppelt ist, um einen Strom zu erzeugen, der das Erstellen des für die Niederfrequenzkomponente repräsentativen ersten Signals ermöglicht.

8. Vorrichtung nach Anspruch 7, **dadurch gekennzeichnet, daß** der Niederfrequenzkanal in dem Primärteil einen Schaltkreis (116) zur Linearisierung des Optokopplers (114) umfaßt, der mit dem elektrooptischen Sender verbunden ist.

9. Vorrichtung nach Anspruch 8, **dadurch gekennzeichnet, daß** das Korrektursignal (V_{COR}) an den Linearisierungsschaltkreis (116) angelegt wird.

10. Vorrichtung nach einem der Ansprüche 4 bis 6, **dadurch gekennzeichnet, daß** der Hochfrequenzkanal einen Transformator (108; 108') umfaßt, der einen Teil der galvanischen Isolationsbarriere (116) bildet und eine in dem Primärteil befindliche Primärseite (P1, P2; P'1) und eine in dem Sekundärteil befindliche Sekundärseite (S1, S2; S'1) aufweist, um die Hochfrequenzkomponente mit Hilfe einer an der Sekundärseite des Transformators abgegriffenen Spannung zu erhalten und um das für die Hochfrequenzkomponente repräsentative zweite Signal mit Hilfe einer an der Primärseite des Transformators abgegriffenen Spannung zu erhalten.

11. Vorrichtung nach Anspruch 10, **dadurch gekennzeichnet, daß** das Korrektursignal (V_{COR}) in Form einer an die Primärseite des Transformators angelegten Spannung vorliegt.

12. Vorrichtung nach einem der Ansprüche 1 bis 11, **dadurch gekennzeichnet, daß** der Regelkreis eine obere Grenzfrequenz aufweist, die wenigstens 100-mal höher als die untere Grenzfrequenz des Hochfrequenzkanals ist.

13. Elektrisches Meßinstrument, das mit einer Vorrichtung zur analogen Isolierung nach einem der Ansprüche 1 bis 12 ausgestattet ist.

## Claims

1. An analog isolation device (100; 200; 300; 400) comprising a primary part (102; 202; 302; 402) having an input (A1, A2) adapted to receive an input signal (Sᵢ) and a secondary part (104; 204; 304; 404) separated from the primary part by an electrical isolation barrier and having an output (O1) for delivering an output signal (Sₒ) reproducing the input signal;
· the primary part and the secondary part including a high-frequency channel having a low cut-off frequency and configured to receive the input signal in the primary part and to produce a high-frequency component in the secondary part from the input signal, and a low-frequency channel having a high cut-off frequency and configured to receive the input signal in the primary part and to produce a low-frequency component in the secondary part from the input signal, in order to form the output signal from the high-frequency and low-frequency components;
the device being **characterized by** a control circuit (D1, 132; D'1, 132) configured to receive, in the primary part, a setpoint signal (S_{ic}) representative of the input signal (Sᵢ) and a so-called image signal (Sₒᵢₘ) representative of the output signal (Sₒ), and to apply in the high-frequency and/or low-frequency channel a correction signal (V_{COR}) as a function of the difference between the image signal and the setpoint signal in order to cause that difference to tend towards zero.

2. A device according to claim 1, **characterized in that** the correction signal (V_{COR}) is applied only to the low-frequency channel.

3. A device according to claim 1, **characterized in that** the correction signal (V_{COR}) is applied only to the high-frequency channel.

4. A device according to any one of claims 1 to 3, **characterized in that** the primary part (102) comprises a summing element adapted to produce the image signal (Sₒᵢₘ) by summing a first signal representative of said low-frequency component and a second signal representative of said high-frequency component.

5. A device according to claim 4, **characterized in that** the first signal and the second signal are in the form of currents.

6. A device according to claim 4, **characterized in that** the first signal and the second signal are in the form of voltages.

7. A device according to any one of claims 4 to 6, **characterized in that** the low-frequency channel comprises an electro-optical coupler (114) forming part of the electrical isolation barrier and having an electro-optical emitter (LED), a first opto-electrical receiver (Dₛ) situated in the secondary part and coupled to the emitter to produce a current enabling of said low-frequency component to be generated, and a second opto-electrical receiver (Dₚ) situated in the primary part and coupled to the emitter to produce a current enabling said first signal representative of said low-frequency component to be generated.

8. A device according to claim 7, **characterized in that** the low-frequency channel comprises, in the primary part, a linearization circuit (116) for linearization of the opto-coupler (114) connected to the electro-optical emitter.

9. A device according to claim 8, **characterized in that** the correction signal (V_{COR}) is applied to the linearization circuit (116).

10. A device according to any one of claims 4 to 6, **characterized in that** the high-frequency channel includes a transformer (108; 108') forming part of the electrical isolation barrier (116) and having a primary (P1, P2; P'1) situated in the primary part and a secondary (S1, S2; S'1) situated in the secondary part to obtain said high-frequency component from a voltage taken from the secondary of the transformer and to obtain said second signal representative of said high-frequency component from a voltage taken from the primary of the transformer.

11. A device according to claim 10, **characterized in that** the correction signal (V_{COR}) is in the form of a voltage applied to the primary of the transformer.

12. A device according to any one of claims 1 to 11, **characterized in that** the control circuit has a high cut-off frequency at least 100 times greater than the low cut-off frequency of the high-frequency channel.

13. An electrical measuring instrument provided with an analog isolation device according to any one of claims 1 to 12.
